# EUROPEAN PATENT APPLICATION

(11) **EP 3 978 797 A1**
(43) Date of publication of application: **06.04.2022**
(21) Application number: 20780549.0
(22) Date of filing: 21.08.2020
(51) Int. Cl.: F21S 8/00, F21V 23/00, F21Y 115/10

(54) **LED LIGHT-EMITTING SOURCE DEVICE AND MANUFACTURING METHOD THEREFOR**

(71) Applicant: Ko, Yin-Hu, New Taipei City, Taiwan 220 (TW)
(72) Inventor: Ko, Yin-Hu, New Taipei City, Taiwan 220 (TW)
(74) Representative: Viering, Jentschura & Partner mbB Patent- und Rechtsanwälte
(86) International application number: PCT/CN2020/110483
(87) International publication number: WO 2022/036681

(57) **Abstract**

An LED light source device includes a first substrate, which is light transmittable and includes a first joining surface; at least two terminal pins, each of which includes an internal connection portion connected to a first joining surface of the first substrate and an external connection portion exposed outside the first joining surface; a control chip and an LED chip mounted to the first joining surface of the first substrate; a conductive wire mounted to the first joining surface of the first substrate and connected to the control chip, the LED chip, and the terminal pins; a second substrate, which is light transmittable and includes a second joining surface laminated on the first joining surface of the first substrate to have the conductive wire, the control chip, the LED chip, and the internal connection portions of the terminal pins enclosed between the first joining surface and the second joining surface.

## Description

### TECHNICAL FIELD OF THE INVENTION

The present invention relates to a light-emitting diode (LED) based lighting product, and more particularly to an LED light source device and a manufacturing method thereof.

### DESCRIPTION OF THE PRIOR ART

Generally speaking, conventional LED packaging that is currently adopted is primarily packaging carried out based on a printed circuit board (PCB) layout, in which the size and shape of a substrate are fixed before a mold is made. Each specific type of substrate needs a set of molds and this significantly increases the fabrication cost. Further, wiring layout cannot be changed. Thus, it suffers problems of high fabrication cost, fixed size and shape, and thus poor universality.

Further, for the LED light sources that are currently known, to make light emitting in various shapes or characters requires an assembly of SMD elements. Such an SMD assembly emits only at one single side, and consequentially, the lighting performance is imperfect.

### SUMMARY OF THE INVENTION

In view of the above, it is desired to overcome the prior art drawbacks that the known LED packaging suffers high fabrication cost, having fixed size and shape that lead to poor universality, and poor lighting performance.

Thus, the present invention provides an LED light source device, which comprises: a first substrate, which is transmittable to light and includes a first joining surface; at least two terminal pins, wherein each of the terminal pins includes an internal connection portion and an external connection portion, the internal connection portion of each of the terminal pins being connected to the first joining surface of the first substrate, the external connection portion of each of the terminal pins being exposed outside the first joining surface; at least one control chip, which is mounted to the first joining surface of the first substrate; at least one LED chip, which is mounted to the first joining surface of the first substrate; at least one conductive wire, which is mounted to the first joining surface of the first substrate and is connected to the control chip, the LED chip, and the internal connection portions of the terminal pins to provide electrical connection between the control chip, the LED chip, and the terminal pins; a second substrate, which is transmittable to light and includes a second joining surface, the second joining surface being laminated on and connected to the first joining surface of the first substrate so that the conductive wire, the control chip, the LED chip, and the internal connection portions of the terminal pins are enclosed between the first joining surface of the first substrate and the second joining surface of the second substrate. As such, an effect of emitting light along the entire periphery can be achieved.

Further, at least one conductive plate is further included. The conductive plate is mounted to the first joining surface of the first substrate and connected to the conductive wire.

By adopting the LED light source device of the above-described technical solution, since both the first substrate and the second substrate are light transmittable, the present invention may achieve an effect of emitting light alone an entire periphery the present invention enables light emission from the entire periphery of the device, and thus with the same consumption of energy (power), the present invention provides brightness that is at least twice of that of the prior art, and therefore, utilization of energy can be greatly enhanced and consumers' need for high-brightness LED light source can be satisfied.

The present invention also provides a method for manufacturing an LED light source device, which comprises the following steps: Step A: preparing a terminal-pin material plate, wherein the terminal-pin material plate comprises at least two terminal pins; Step B: preparing a first substrate, wherein the terminal-pin material plate is placed on a first mold, wherein the first mold includes at least one first mold cavity; a glue is injected into the first mold, so that after the glue is cooled and cured, the first substrate that is transmittable to light is obtained, and an internal connection portion at one end of each of the terminal pins is connected to a first joining surface of the first substrate, and a portion of each of the terminal pins that is not connected to the first substrate is an external connection portion; Step C: mounting chips and connecting with wire bonding, wherein at least one control chip, at least one LED chip, and at least one conductive wire are mounted on the first joining surface of the first substrate, such that the conductive wire is connected to the control chip, the LED chip, and the internal connection portions of the terminal pins to for electrical connection therebetween; Step D: laminating a second substrate, wherein the first substrate, together with the terminal-pin material plate, is deposited on a second mold, the second mold including at least one second mold cavity, such that the first joining surface of the first substrate faces toward the second mold cavity; a glue is injected into the second mold, so that after the glue is cooled and cured, the second substrate that is transmittable to light is obtain, wherein a second joining surface of the second substrate is laminated on and connected to the first joining surface of the first substrate and the internal connection portions of the terminal pins, the control chip, the LED chip, and the conductive wire are enclosed between the first joining surface of the first substrate and the second joining surface of the second substrate; Step E: cutting to a desired shape, wherein the first substrate and the second substrate are subjected to cutting to a desired shape and portions of the first substrate, the second substrate, and the terminal-pin material plate that are outside a predetermined shape are cut and removed to obtain a product of the LED light source device. As such, advantages of reducing fabrication cost, improving universality, being good for mass production, and enhanced light emission performance are achieved.

Further, in Step A, the terminal-pin material plate is made of one of sliver-plate copper or silver-plated iron, and the terminal-pin material plate further includes a material frame, the two terminal pins extending from an inner edge of the material frame.

Further, in Step B and Step D, the glue is one of epoxy resin, silicone rubber, ceramics, and aluminum oxide.

Further, the epoxy resin comprises one of bisphenol A epoxy resin, bisphenol F epoxy resin, phenolic epoxy resin, tetrabromobisphenol epoxy resin, rubber-modified epoxy resin, cyclic epoxy resin, and aliphatic epoxy resin or a combination thereof.

Further, in Step C, at least one conductive plate is mounted on the first joining surface of the first substrate, and the conductive wire is connected to the conductive plate.

Further, in Step B and Step D, the glue comprises a phosphor powder.

Further, in Step B and Step D, the glue comprises a light diffusing agent.

By adopting the above method for manufacturing an LED light source device, the present invention is such that the first substrate and the second substrate are formed first and then subjected to cutting for the shape or outer configuration thereof, and this makes it possible not to prepare multiple molds of different shapes and the cost of mold fabrication can be reduced and mass production can be made in a more efficient way, with the production line being of enhanced flexibility and adaptability.

The present invention also provides a method for manufacturing an LED light source device, which comprises the following steps: Step A: preparing a terminal-pin material plate, wherein the terminal-pin material plate comprises at least two terminal pins, and each of the terminal pins includes an internal connection portion and an external connection portion; Step B: laying a wire, wherein at least one conductive wire is electrically connected to each of the internal connection portions of the two terminal pins, and solder pads are set at predetermined locations of the conductive wire; Step C: preparing a first substrate, wherein the terminal-pin material plate is placed on a first mold, the first mold including at least one first mold cavity; a glue is injected into the first mold cavity, so that after the glue is cooled and cured, the first substrate that is transmittable to light is obtained, and the internal connection portions of the two terminal pins and the conductive wire are connected to a first joining surface of the first substrate; Step D: mounting chips, wherein at least one control chip and at least one LED chip are mounted to the solder pads of the conductive wire, so that the control chip and the LED chip are located on the first joining surface of the first substrate and are in electrical connection with the conductive wire and the terminal pins; Step E: laminating a second substrate, wherein the first substrate, together with the terminal-pin material plate, is placed on a second mold, the second mold including at least one second mold cavity, such that the first joining surface of the first substrate faces toward the second mold cavity; a glue is injected into the second mold cavity, so that after the glue is cooled and cure, the second substrate that is transmittable to light is obtained, wherein a second joining surface of the second substrate is laminated on and connected to the first joining surface of the first substrate, and the internal connection portions of the terminal pins, the control chip, the LED chip, and the conductive wire are enclosed between the first joining surface of the first substrate and the second joining surface of the second substrate; Step F: cutting to a desired shape, wherein the first substrate and the second substrate are subjected to cutting to a desired shape and portions of the first substrate, the second substrate, and the terminal-pin material plate that are outside a predetermined shape are cut and removed to obtain a product of the LED light source device.

The present invention further provides a method for manufacturing a light-emitting diode (LED) light source device, which comprises the following steps: Step A: preparing a terminal-pin material plate, wherein the terminal-pin material plate comprises at least two terminal pins, and each of the terminal pins includes an internal connection portion and an external connection portion; Step B: laying a wire and mounting chips, wherein at least one conductive wire is electrically connected to each of the internal connection portions of the two terminal pins, and solder pads are set at predetermined locations of the conductive wire; and at least one control chip and at least LED chip are mounted to the solder pads of the conductive wire, so that the control chip and the LED chip are electrically connected to the conductive wire and the terminal pins; Step C: preparing a first substrate, wherein the terminal-pin material plate is placed on a first mold, the first mold including at least one first mold cavity; a glue is injected into the first mold cavity, so that after the glue is cooled and cured, the first substrate that is transmittable to light is obtained, and the internal connection portions of the two terminal pins and the conductive wire are connected to a first joining surface of the first substrate; Step D: laminating a second substrate, wherein the first substrate, together with the terminal-pin material plate, is placed on a second mold, the second mold including at least one second mold cavity, such that the first joining surface of the first substrate faces toward the second mold cavity; a glue is injected into the second mold cavity, so that after the glue is cooled and cure, the second substrate that is transmittable to light is obtained, wherein a second joining surface of the second substrate is laminated on and connected to the first joining surface of the first substrate, and the internal connection portions of the terminal pins, the control chip, the LED chip, and the conductive wire are enclosed between the first joining surface of the first substrate and the second joining surface of the second substrate; Step E: cutting to a desired shape, wherein the first substrate and the second substrate are subjected to cutting to a desired shape and portions of the first substrate, the second substrate, and the terminal-pin material plate that are outside a predetermined shape are cut and removed to obtain a product of the LED light source device.

Although the two later methods for manufacturing an LED light source device include steps that are not completely identical to those of the first method, yet the same effect can be achieved and the same product can be made.

### BRIEF DESCRIPTION OF THE DRAWINGS

FIGS. 1-7 are schematic views demonstrating a flow of a method for manufacturing an LED light source device according to the present.
FIG. 8 is a perspective view showing a preferred embodiment of an LED light source device according to the present invention.
FIG. 9 is a cross-sectional view of the embodiment of FIG. 8.
FIG. 10 is a schematic view showing another embodiment of the LED light source device according to the present invention.
FIG. 11 is a block diagram demonstrating a flow of a first embodiment of the method for manufacturing an LED light source device according to the present invention.
FIG. 12 is a schematic view showing another embodiment of the LED light source device according to the present invention.
FIG. 13 is a block diagram demonstrating a flow of a second embodiment of the method for manufacturing an LED light source device according to the present invention.
FIG. 14 is a block diagram demonstrating a flow of a third embodiment of the method for manufacturing an LED light source device according to the present invention.
FIG. 15 is a schematic view showing a part of another embodiment of the LED light source device according to the present invention.
FIG. 16 is a schematic view showing assembly of parts of another embodiment of the LED light source device according to the present invention.

### DETAILED DESCRIPTION OF THE PREFERRED EMBODIMENT

For better understanding of the features and advantages of the present invention, a description is provided below with reference to embodiments of the present invention and the attached drawings.

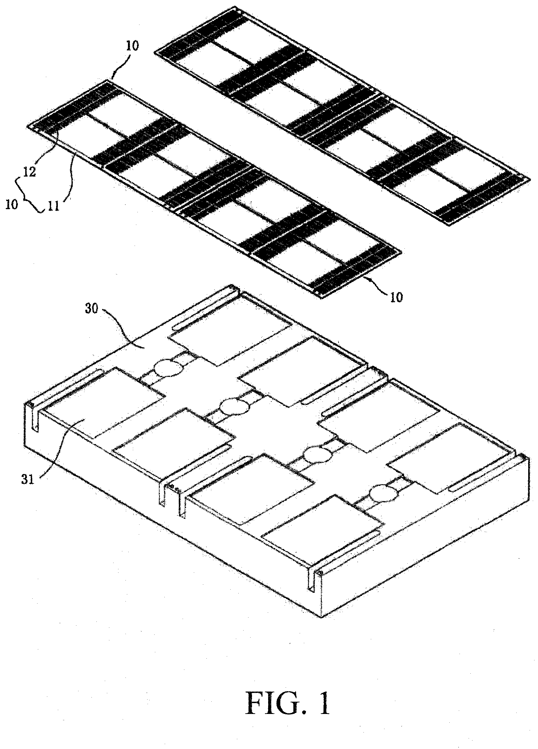

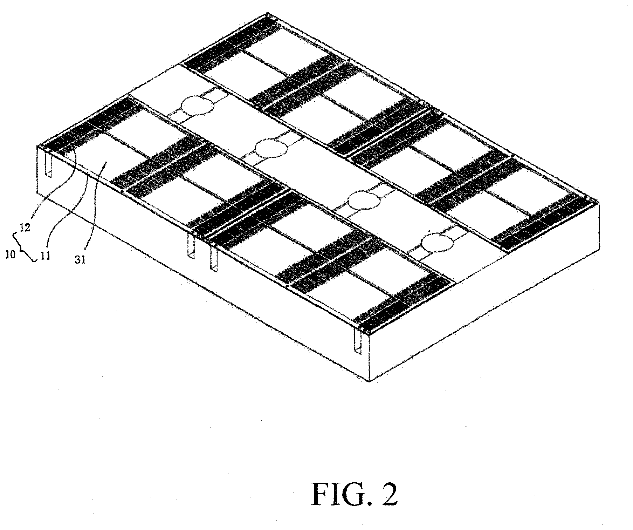

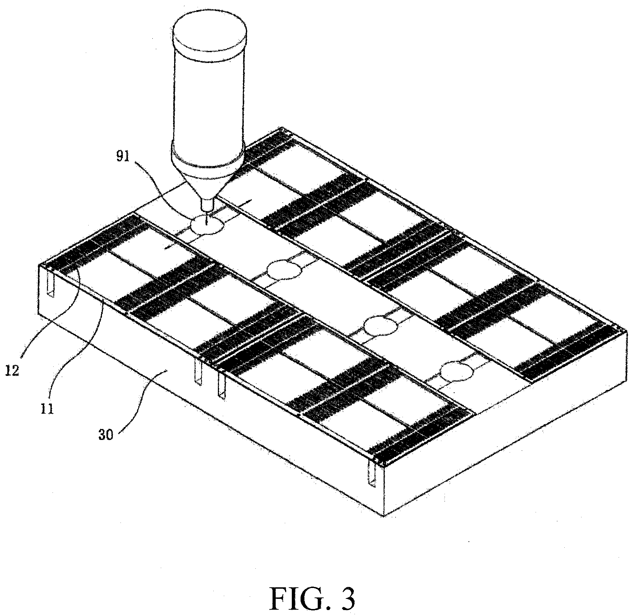

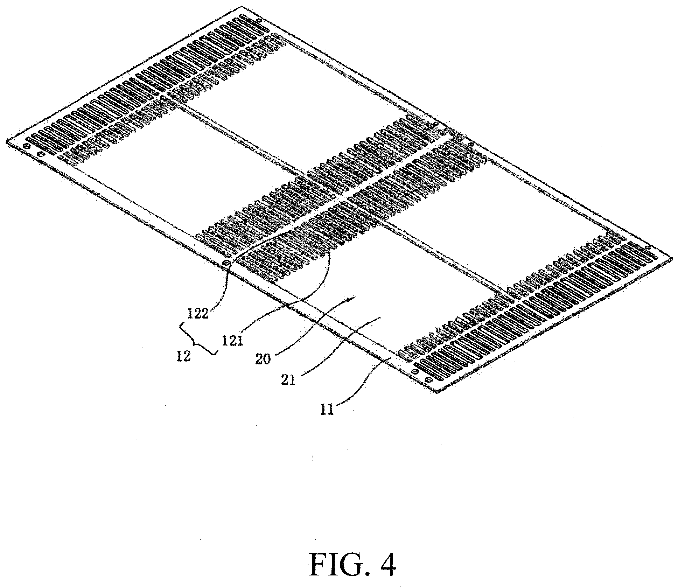

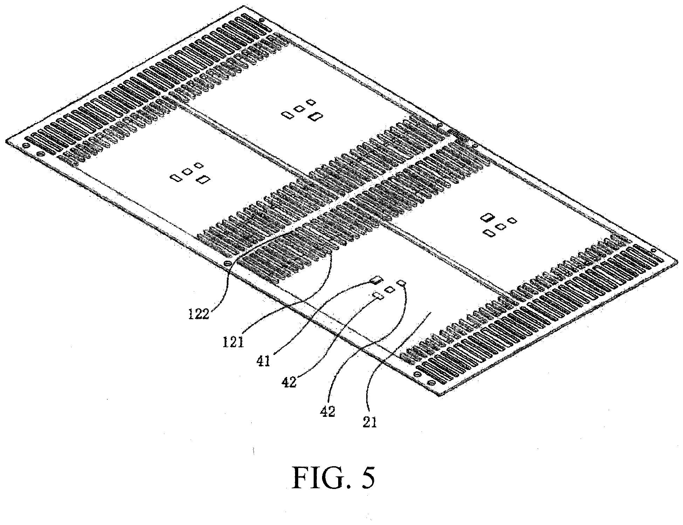

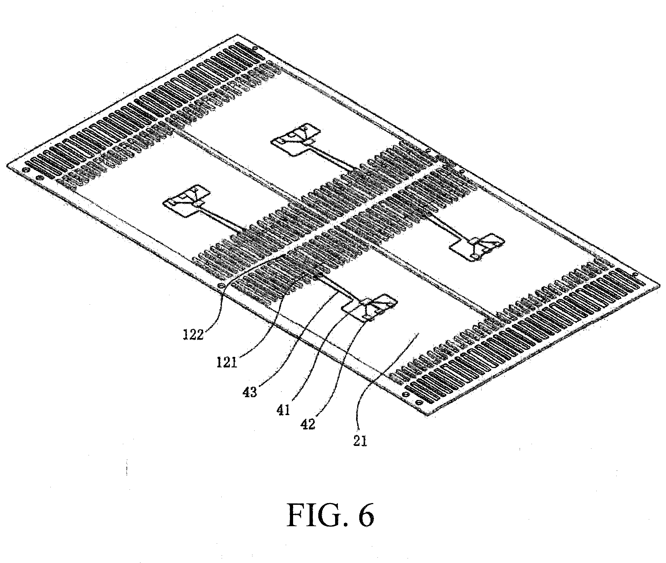

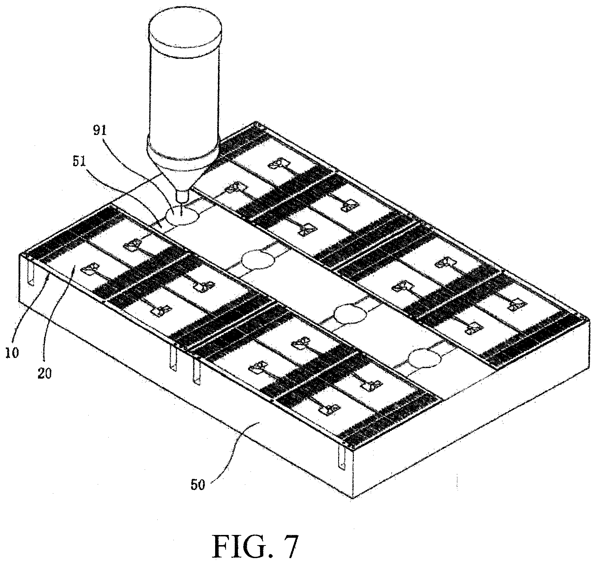

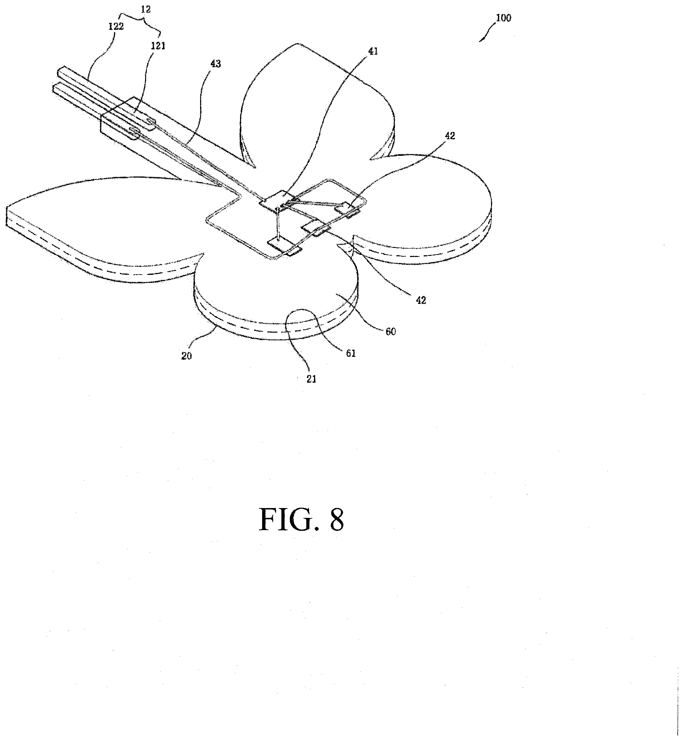

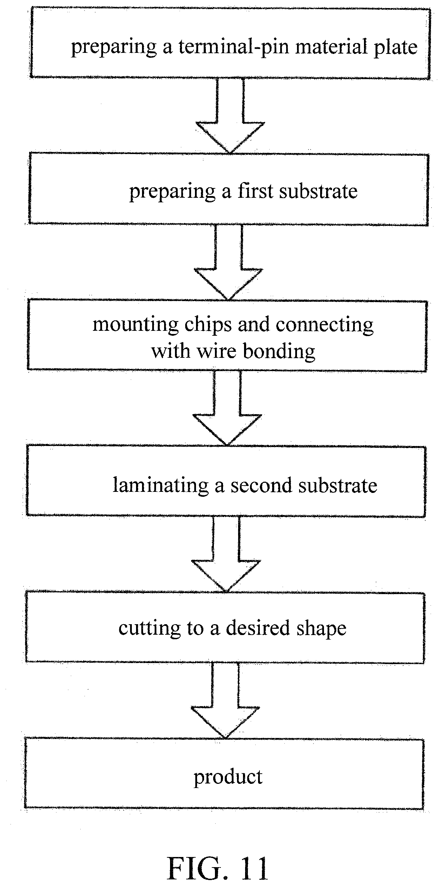

Referring to FIGS. 1-11, a method for manufacturing an LED light source device 100 according to a first preferred embodiment of the present invention will be described, which comprises the followings steps:
Step A: preparing a terminal-pin material plate 10, in which, referring to FIGS. 1 and 11, at least one terminal-pin material plate 10 is provided, wherein the terminal-pin material plate 10 can be self-fabricated or purchased from a supply source. The terminal-pin material plate 10 is made of a material of copper plated with silver or iron plated with silver and the terminal-pin material plate 10 includes a material frame 11 and at least two terminal pins 12 extending from an inner edge of the material frame 11.
Step B: preparing a first substrate 20, in which , referring to FIGS. 2, 3, 4, and 11, a first mold 30 is provided, wherein the first mold 30 includes at least one first mold cavity 31; the terminal-pin material plate 10 is deposited on the first mold 30, such that on end of the two terminal pins 12 corresponds to and above the first mold cavity 31 (as shown in FIG. 2); and a glue 91 is injected into the first mold cavity 31 (as shown in FIG. 3), wherein the glue is injected at a temperature of 100-160°C for a time period of 3-15 minutes, and the glue 91 can be a material of epoxy resin (such as bisphenol A epoxy resin, bisphenol F epoxy resin, phenolic epoxy resin, tetrabromobisphenol epoxy resin, rubber-modified epoxy resin, cyclic epoxy resin, aliphatic epoxy resin, or one of the mixtures thereof and any combination thereof), silicone rubber, ceramics, and aluminum oxide. After the glue 91 is cooled and cured in the first mold cavity 31, the first substrate 20 that is transmittable to light is obtained, and under this condition, the at least two terminal pins 12 of the terminal-pin material plate 10 are each connected, at one end thereof, to a first joining surface 21 of the first substrate 20, meaning each terminal pin 12 has a portion that is connected to the first substrate 20 and forms an internal connection portion 121 and a portion that extends outside of the first substrate 20 and is not connected to the first substrate 20 and forms an external connection portion 122 (as shown in FIG. 4).
Step C: mounting chips and connecting with wire bonding, in which, referring to FIGS. 5, 6 and 11, the terminal-pin material plate 10 is moved, together with the first substrate 20, from the first mold 30 to a worktable, and at least one control chip 41 and at least one LED chip 42 are mounted to the first joining surface 21 of the first substrate 20 (as shown in FIG. 5) and wire bonding is applied to provide a conductive wire 43 on the first joining surface 21 of the first substrate 20 so that the conductive wire 43 is connected to the control chip 41, the LED chip 42, and the internal connection portions 121 of the terminal pins 12 (as shown in FIG. 6), and the control chip 41, the LED chip 42, and the terminal pins 12 are electrically connected to each other by means of the conductive wire 43.
Step D: laminating a second substrate 60, in which, referring to FIGS. 7 and 11, a second mold 50 is provided, wherein the second mold 50 includes at least one second mold cavity 51; the first substrate 20, together with the terminal-pin material plate 10, is deposited on the second mold 50, such that the first joining surface 21 of the first substrate 20 faces toward the second mold cavity 51; and a glue 91 is injected into the second mold cavity 51 (as shown in FIG. 7), wherein the glue is similarly injected at a temperature of 100-160°C for a time period of 3-15 minutes, and the glue 91 can be of a material that is identical to that of the first substrate 20. After the glue 91 is cooled and cured in the second mold cavity 51, the second substrate 60 that is transmittable to light is obtained, wherein a second joining surface 61 of the second substrate 60 is laminated on and connected to the first joining surface 21 of the first substrate 20, and the internal connection portions 121 of the terminal pins 12, the control chip 41, the LED chip 42, and the conductive wire 43 are all enclosed between the first joining surface 21 of the first substrate 20 and the second joining surface 61 of the second substrate 60.
Step E: cutting to a desired shape, in which, referring to FIGS. 8 and 11, the first substrate 20 and the second substrate 60 are subjected to cutting to form a desired shape, meaning portions of the first substrate 20, the second substrate 60, and the terminal-pin material plate 10 that are outside a predetermined shape are cut and removed to thereby obtain a product of the LED light source device 100 according to the present invention.

The above description provides an introduction to the manufacturing method of the LED light source device 100 according to the first embodiment of the present invention, and the following will provide a description to the features of the present invention.

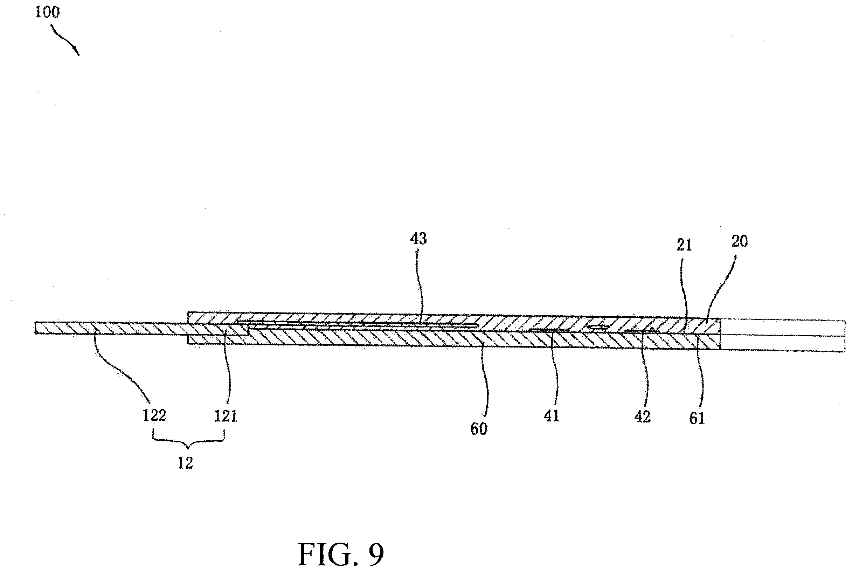

Firstly, the structure of the LED light source device 100 according to the present invention, as shown in FIGS. 8 and 9, is manufactured with the above steps of the manufacturing method described above, and such a structure comprises a first substrate 20, a second substrate 60, at least two terminal pins 12, at least one control chip 41, at least one LED chip 42, and at least one conductive wire 43. The first substrate 20 has a first joining surface 21, and the second substrate 60 has a second joining surface 61. The two terminal pins 12 each include an internal connection portion 121 and an external connection portion 122. The internal connection portion 121 is connected to the first joining surface 21 of the first substrate 20, while the external connection portion 122 is exposed or located outside the first substrate 20. The control chip 41, the LED chip 42, and the conductive wire 43 are mounted to the first joining surface 21 of the first substrate 20, and the conductive wire 43 connects the control chip 41, the LED chip 42 and the internal connection portions 121 of the terminal pins 12 for electrical connection therebetween. The second joining surface 61 of the second substrate 60 is laminated on and connected to the first joining surface 21 of the first substrate 20, and thus, the conductive wire 43, the control chip 41, the LED chip 42, and the internal connection portions 121 of the terminal pins 12 are housed between the first joining surface 21 of the first substrate 20 and the second joining surface 61 of the second substrate 60.

As such, since both the first substrate 20 and the second substrate 60 are light-transmittable, the present invention may achieve an effect of emitting light alone an entire periphery the present invention enables light emission from the entire periphery of the device, and thus with the same consumption of energy (power), the present invention provides brightness that is at least twice of that of the prior art, and therefore, utilization of energy can be greatly enhanced and consumers' need for high-brightness LED light source can be satisfied.

Further, in the present invention, the first substrate 20 and the second substrate 60 are first formed and then subjected to cutting for the shape or outer configuration thereof, and this makes it possible not to prepare multiple molds of different shapes and the cost of mold fabrication can be reduced and mass production can be made in a more efficient way, with the production line being of enhanced flexibility and adaptability.

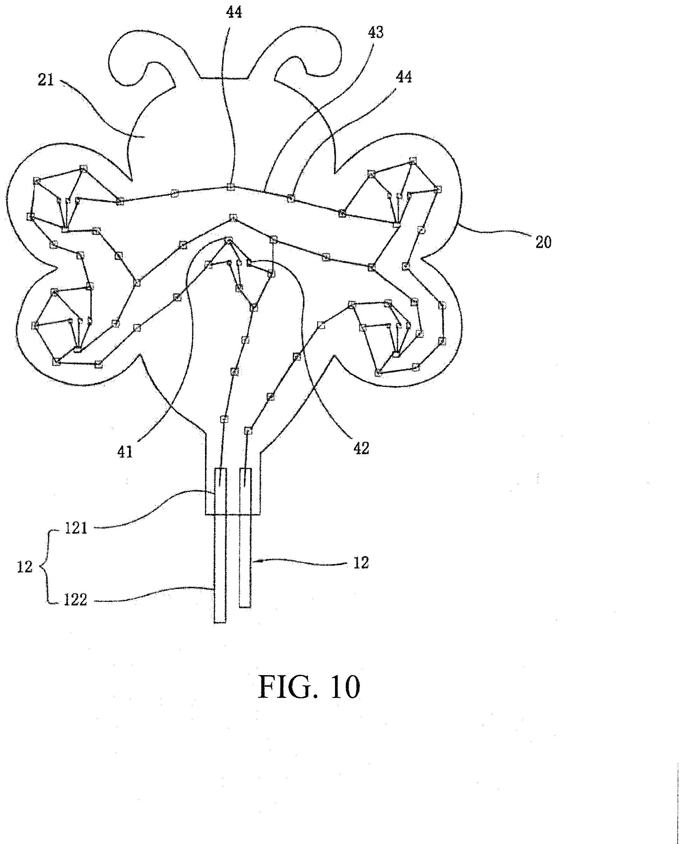

Next, in the above embodiment, in the operation of mounting chips and connecting with wire bonding carried out in Step C, a plurality of conductive plates 44 are mounted on the first joining surface 21 of the first substrate and the conductive wire 43 is made connecting with the conductive plates 44 (as shown in FIG. 10), so that breaking of the conductive wire 43 can be avoided.

In the above embodiment, although in Step C, the operation is carried out by first mounting the control chip 41, the LED chip 42 (and the conductive plates 44), and the conductive wire 43 is then formed. In practice, it is possible that in Step C, the conductive wire 43 is first formed, and then, the control chip 41, the LED chip 42 (and the conductive plates 44) are mounted, to achieve the same effect.

In the above embodiment, it is also possible to add a phosphor powder in the raw material of the first substrate 20 and the second substrate 60 (which, in the above, is the glue 91), and the phosphor powder can be one of YAG phosphor, TAG phosphor, aluminate, silicate, nitride, and oxynitride, or a combination thereof.

In the above embodiment, it is also possible to add a light diffusing agent in the raw material of the first substrate 20 and the second substrate 60 (which, in the above, is the glue 91), and the light diffusing agent can be one of nano-barium sulfate, calcium carbonate, silicon dioxide, acrylic light diffusing agent, styrene light diffusing agent, and acrylic rein light diffusing agent, to achieve an effect of making light softening and matte.

In the above embodiment, for mass production, the first mold 30 and the second mold 50 can be different molds in order to enhance the efficiency of the production line. For production with a small quantity, the first mold 30 and the second mold 50 can be of the same mold to reduce the cost for molds.

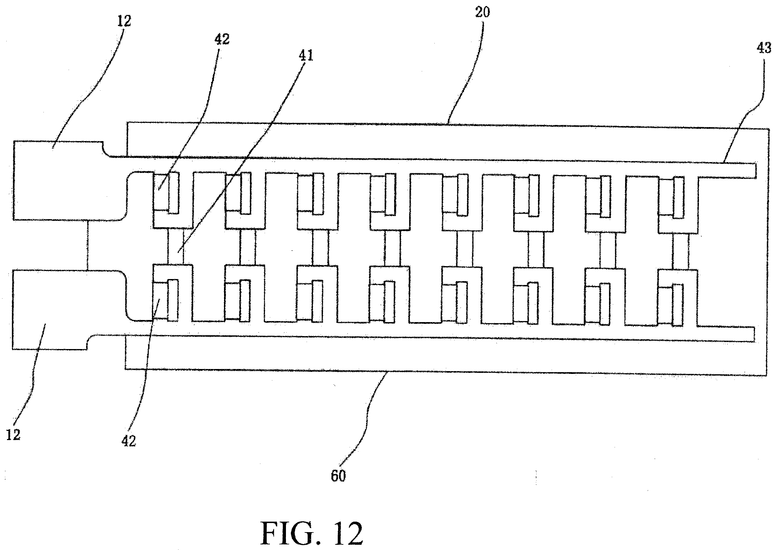

Referring to FIG. 12, in practice, the present invention enables cutting to different shapes according to an actual requirement of a customer, and this widens the applicability thereof.

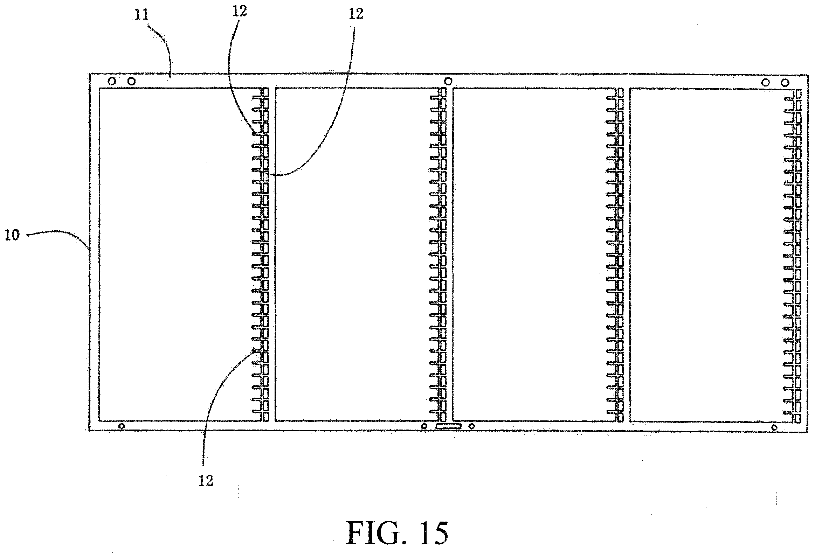

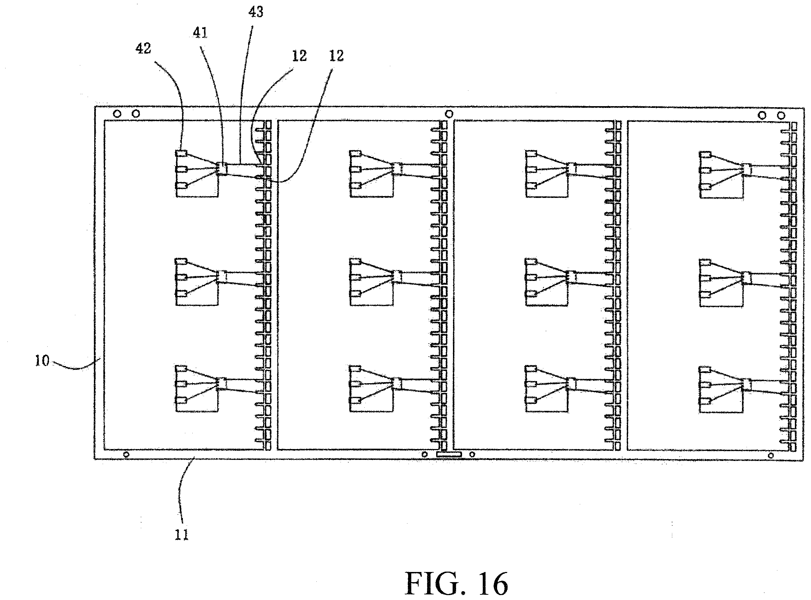

Further, although in the above-described embodiment, the terminal-pin material plate 10 is such that the multiple terminal pins 12 project or extend from two opposite inner edges of the material frame 11. However, in practice, as shown in FIG. 15, the terminal pins 12 can be made to extend from the same inner edge of the material frame 11, in order to greater reduce the fabrication cost and also to provide the control chip 41, the LED chip 42, and the conductive wire 43 with an enlarged space for arrangement and mounting (as shown in FIG. 16).

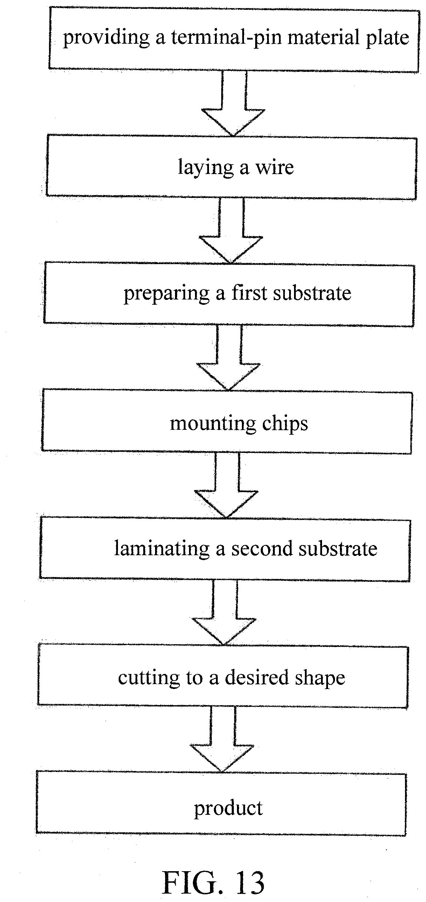

Referring to FIG. 13, a method for manufacturing an LED light source device according to a second preferred embodiment of the present invention will be described, which comprises the followings steps:
Step A: providing a terminal-pin material plate, in which, referring to FIG. 13, at least one terminal-pin material plate is provided, wherein the terminal-pin material plate, similar to the previous embodiment, includes a material frame and at least two terminal pins each extending from an inner edge of the material frame, each of the terminal pins including an internal connection portion and an external connection portion.
Step B: laying a wire, in which, referring to FIG. 13, at least one conductive wire is provided to electrically connect to each of the internal connection portions of the two terminal pins, and solder pads are set at predetermined locations of the conductive wire.
Step C: preparing a first substrate, in which , referring to FIG. 13, a first mold is provided, wherein the first mold includes at least one first mold cavity; the terminal-pin material plate is deposited on the first mold, such that the internal connection portions of the two terminal pins correspond to and above the first mold cavity; and a glue is injected into the first mold cavity. After the glue is cooled and cured in the first mold cavity, the first substrate that is transmittable to light is obtained, and under this condition, the internal connection portions of the two terminal pins and the conductive wire are connected to the first joining surface of the first substrate.
Step D: mounting chips, in which, referring to FIG. 13, the terminal-pin material plate and the conductive wire are moved, together with the first substrate, from the first mold to a worktable, and at least one control chip and at least one LED chip are mounted to the solder pads of the conductive wire, so that the control chip and the LED chip are located on the first joining surface of the first substrate and are in electrical connection with the conductive wire and the terminal pins.
Step E: laminating a second substrate, in which, referring to FIG. 13, a second mold is provided, wherein the second mold includes at least one second mold cavity; the first substrate, together with the terminal-pin material plate, is deposited on the second mold, such that the first joining surface of the first substrate faces toward the second mold cavity; and a glue is injected into the second mold cavity. After the glue is cooled and cured in the second mold cavity, the second substrate transmittable to light is obtained, wherein a second joining surface of the second substrate is laminated on and connected to the first joining surface of the first substrate, and the internal connection portions of the terminal pins, the control chip, the LED chip, and the conductive wire are all enclosed between the first joining surface of the first substrate and the second joining surface of the second substrate.
Step F: cutting to a desired shape, in which, referring to FIG. 13, the first substrate and the second substrate are subjected to cutting to form a desired shape, meaning portions of the first substrate, the second substrate, and the terminal-pin material plate that are outside a predetermined shape are cut and removed to thereby obtain a product of the LED light source device according to the present invention.

Although the method of the instant embodiment includes steps that are not completely identical to those of the previous embodiment, yet the same effect can be achieved and the same product can be made.

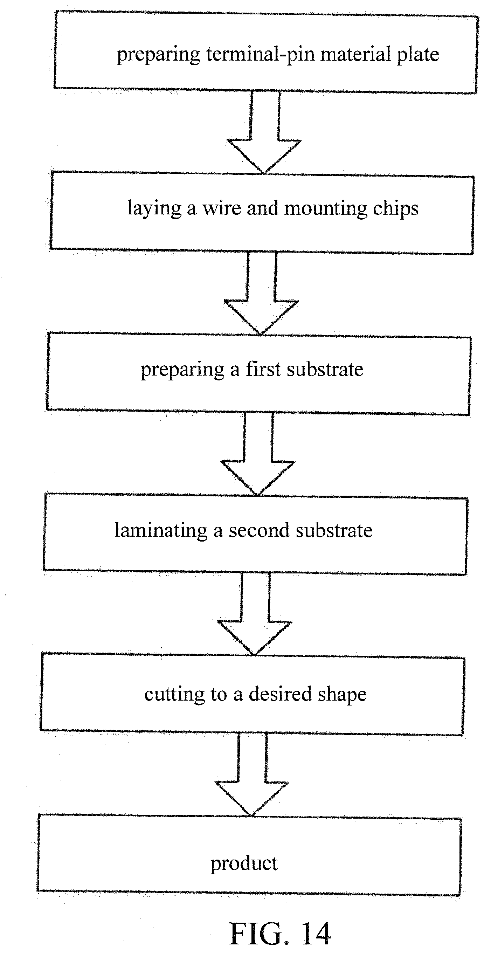

Referring to FIG. 14, a method for manufacturing an LED light source device according to a third preferred embodiment of the present invention will be described, which comprises the followings steps:
Step A: preparing terminal-pin material plate, in which, referring to FIG. 14, at least one terminal-pin material plate is provided, wherein the terminal-pin material plate, similar to the previous embodiments, includes a material frame and at least two terminal pins extending from an inner edge of the material frame, each of the terminal pins including an internal connection portion and an external connection portion.
Step B: laying a wire and mounting chips, in which referring to FIG. 14, at least one conductive wire is provided to electrically connect to each of the internal connection portions of the two terminal pins, and solder pads are set at predetermined locations of the conductive wire, and at least one control chip and at least one LED chip are mounted to the solder pads of the conductive wire, so that the control chip and the LED chip are in electrical connection with the conductive wire and the terminal pins.
Step C: preparing a first substrate, in which, referring to FIG. 14, a first mold is provided, wherein the first mold includes at least one first mold cavity; the terminal-pin material plate is deposited on the first mold, such that the internal connection portions of the two terminal pins correspond to and above the first mold cavity; and a glue is injected into the first mold cavity. After the glue is cooled and cured in the first mold cavity, the first substrate that is transmittable to light is obtained, and under this condition, the internal connection portions of the two terminal pins and the conductive wire are connected to a first joining surface of the first substrate.
Step D: laminating a second substrate, in which, referring to FIG. 14, a second mold is provided, wherein the second mold includes at least one second mold cavity; the first substrate, together with the terminal-pin material plate, is deposited on the second mold, such that the first joining surface of the first substrate faces toward the second mold cavity; and a glue is injected into the second mold cavity. After the glue is cooled and cured in the second mold cavity, the second substrate transmittable to light is obtained, wherein a second joining surface of the second substrate is laminated on and connected to the first joining surface of the first substrate, and the internal connection portions of the terminal pins, the control chip, the LED chip, and the conductive wire are all enclosed between the first joining surface of the first substrate and the second joining surface of the second substrate.
Step E: cutting to a desired shape, in which, referring to FIG. 14, the first substrate and the second substrate are subjected to cutting to form a desired shape, meaning portions of the first substrate, the second substrate, and the terminal-pin material plate that are outside a predetermined shape are cut and removed to thereby obtain a product of the LED light source device according to the present invention.

Although the method of the instant embodiment includes steps that are not completely identical to those of the previous embodiments, yet the same effect can be achieved and the same product can be made.

Further, although the disclosed embodiments are not identical to each other in respect of the steps thereof, each LED chip included in each of the embodiments may emit light all in one single direction, or they can be arranged to emit light in different directions, both enabling light to emit in a more omnidirectional manner.

The above provides only some preferred embodiments of the present invention and is not intended limit the scope of embodiment of the present invention. All equivalent variations that a person skilled in the art may made according to the disclosure of the present invention are considered within the scope of the present invention.

## Claims

1. A method for manufacturing a light-emitting diode (LED) light source device, comprising the following steps:
Step A: preparing a terminal-pin material plate,
wherein the terminal-pin material plate comprises at least two terminal pins;
Step B: preparing a first substrate,
wherein the terminal-pin material plate is placed on a first mold, wherein the first mold includes at least one first mold cavity; a glue is injected into the first mold, so that after the glue is cooled and cured, the first substrate that is transmittable to light is obtained, and an internal connection portion at one end of each of the terminal pins is connected to a first joining surface of the first substrate, and a portion of each of the terminal pins that is not connected to the first substrate is an external connection portion;
Step C: mounting chips and connecting with wire bonding,
wherein at least one control chip, at least one LED chip, and at least one conductive wire are mounted on the first joining surface of the first substrate, such that the conductive wire is connected to the control chip, the LED chip, and the internal connection portions of the terminal pins to for electrical connection therebetween;
Step D: laminating a second substrate,
wherein the first substrate, together with the terminal-pin material plate, is deposited on a second mold, the second mold including at least one second mold cavity, such that the first joining surface of the first substrate faces toward the second mold cavity; a glue is injected into the second mold, so that after the glue is cooled and cured, the second substrate that is transmittable to light is obtain, wherein a second joining surface of the second substrate is laminated on and connected to the first joining surface of the first substrate and the internal connection portions of the terminal pins, the control chip, the LED chip, and the conductive wire are enclosed between the first joining surface of the first substrate and the second joining surface of the second substrate;
Step E: cutting to a desired shape,
wherein the first substrate and the second substrate are subjected to cutting to a desired shape and portions of the first substrate, the second substrate, and the terminal-pin material plate that are outside a predetermined shape are cut and removed to obtain a product of the LED light source device.

2. The method for manufacturing the LED light source device according to claim 1, wherein in Step A, the terminal-pin material plate is made of one of sliver-plate copper or silver-plated iron, and the terminal-pin material plate further includes a material frame, the two terminal pins extending from an inner edge of the material frame.

3. The method for manufacturing the LED light source device according to claim 1, wherein in Step B and Step D, the glue is one of epoxy resin, silicone rubber, ceramics, and aluminum oxide.

4. The method for manufacturing the LED light source device according to claim 3, wherein the epoxy resin comprises one of bisphenol A epoxy resin, bisphenol F epoxy resin, phenolic epoxy resin, tetrabromobisphenol epoxy resin, rubber-modified epoxy resin, cyclic epoxy resin, and aliphatic epoxy resin or a combination thereof.

5. The method for manufacturing the LED light source device according to claim 1, wherein in Step C, at least one conductive plate is mounted on the first joining surface of the first substrate, and the conductive wire is connected to the conductive plate.

6. The method for manufacturing the LED light source device according to claim 1, wherein in Step B and Step D, the glue comprises a phosphor powder.

7. The method for manufacturing the LED light source device according to claim 1, wherein in Step B and Step D, the glue comprises a light diffusing agent.

8. A light-emitting diode (LED) light source device, comprising:
a first substrate, which is transmittable to light and includes a first joining surface;
at least two terminal pins, wherein each of the terminal pins includes an internal connection portion and an external connection portion, the internal connection portion of each of the terminal pins being connected to the first joining surface of the first substrate, the external connection portion of each of the terminal pins being exposed outside the first joining surface;
at least one control chip, which is mounted to the first joining surface of the first substrate;
at least one LED chip, which is mounted to the first joining surface of the first substrate;
at least one conductive wire, which is mounted to the first joining surface of the first substrate and is connected to the control chip, the LED chip, and the internal connection portions of the terminal pins to provide electrical connection between the control chip, the LED chip, and the terminal pins;
a second substrate, which is transmittable to light and includes a second joining surface, the second joining surface being laminated on and connected to the first joining surface of the first substrate so that the conductive wire, the control chip, the LED chip, and the internal connection portions of the terminal pins are enclosed between the first joining surface of the first substrate and the second joining surface of the second substrate.

9. The LED light source device according to claim 8, further comprising at least one conductive plate, the conductive plate being mounted to the first joining surface of the first substrate and connected to the conductive wire.

10. A method for manufacturing a light-emitting diode (LED) light source device, comprising the following steps:
Step A: preparing a terminal-pin material plate,
wherein the terminal-pin material plate comprises at least two terminal pins, and each of the terminal pins includes an internal connection portion and an external connection portion;
Step B: laying a wire,
wherein at least one conductive wire is electrically connected to each of the internal connection portions of the two terminal pins, and solder pads are set at predetermined locations of the conductive wire;
Step C: preparing a first substrate,
wherein the terminal-pin material plate is placed on a first mold, the first mold including at least one first mold cavity; a glue is injected into the first mold cavity, so that after the glue is cooled and cured, the first substrate that is transmittable to light is obtained, and the internal connection portions of the two terminal pins and the conductive wire are connected to a first joining surface of the first substrate;
Step D: mounting chips,
wherein at least one control chip and at least one LED chip are mounted to the solder pads of the conductive wire, so that the control chip and the LED chip are located on the first joining surface of the first substrate and are in electrical connection with the conductive wire and the terminal pins;
Step E: laminating a second substrate,
wherein the first substrate, together with the terminal-pin material plate, is placed on a second mold, the second mold including at least one second mold cavity, such that the first joining surface of the first substrate faces toward the second mold cavity; a glue is injected into the second mold cavity, so that after the glue is cooled and cure, the second substrate that is transmittable to light is obtained, wherein a second joining surface of the second substrate is laminated on and connected to the first joining surface of the first substrate, and the internal connection portions of the terminal pins, the control chip, the LED chip, and the conductive wire are enclosed between the first joining surface of the first substrate and the second joining surface of the second substrate;
Step F: cutting to a desired shape,
wherein the first substrate and the second substrate are subjected to cutting to a desired shape and portions of the first substrate, the second substrate, and the terminal-pin material plate that are outside a predetermined shape are cut and removed to obtain a product of the LED light source device.

11. A method for manufacturing a light-emitting diode (LED) light source device, comprising the following steps:
Step A: preparing a terminal-pin material plate,
wherein the terminal-pin material plate comprises at least two terminal pins, and each of the terminal pins includes an internal connection portion and an external connection portion;
Step B: laying a wire and mounting chips,
wherein at least one conductive wire is electrically connected to each of the internal connection portions of the two terminal pins, and solder pads are set at predetermined locations of the conductive wire; and at least one control chip and at least LED chip are mounted to the solder pads of the conductive wire, so that the control chip and the LED chip are electrically connected to the conductive wire and the terminal pins;
Step C: preparing a first substrate,
wherein the terminal-pin material plate is placed on a first mold, the first mold including at least one first mold cavity; a glue is injected into the first mold cavity, so that after the glue is cooled and cured, the first substrate that is transmittable to light is obtained, and the internal connection portions of the two terminal pins and the conductive wire are connected to a first joining surface of the first substrate;
Step D: laminating a second substrate,
wherein the first substrate, together with the terminal-pin material plate, is placed on a second mold, the second mold including at least one second mold cavity, such that the first joining surface of the first substrate faces toward the second mold cavity; a glue is injected into the second mold cavity, so that after the glue is cooled and cure, the second substrate that is transmittable to light is obtained, wherein a second joining surface of the second substrate is laminated on and connected to the first joining surface of the first substrate, and the internal connection portions of the terminal pins, the control chip, the LED chip, and the conductive wire are enclosed between the first joining surface of the first substrate and the second joining surface of the second substrate;
Step E: cutting to a desired shape,
wherein the first substrate and the second substrate are subjected to cutting to a desired shape and portions of the first substrate, the second substrate, and the terminal-pin material plate that are outside a predetermined shape are cut and removed to obtain a product of the LED light source device.
